# EUROPEAN PATENT APPLICATION

(11) **EP 4 624 222 A1**
(43) Date of publication of application: **01.10.2025**
(21) Application number: 24167481.1
(22) Date of filing: 28.03.2024
(51) Int. Cl.: B60L 1/00, B60L 3/00, B60P 3/20, B60R 16/027, B62D 53/00, G01R 31/52, H01R 13/00, B60D 1/62, B60L 3/04, G01R 31/69

(54) **A SYSTEM FOR ENABLING SAFE TRANSMITTAL OF HV ELECTRIC POWER FROM A TOWING VEHICLE TO A TRAILER VEHICLE**

(71) Applicant: VOLVO TRUCK CORPORATION, 405 08 Göteborg (SE)
(72) Inventor: NYSTROM, Mats, 423 53 Torslanda (SE)
(74) Representative: Zacco Sweden AB

(57) **Abstract**

A system (1) for enabling transmittal of high voltage electric power from a towing vehicle (2) to a trailer vehicle (3), the towing vehicle (2) comprising: a source of high voltage electric power (4); a cable connector (5) configured to be connected to a first end connector (6a) of a cable (6) that comprises i) at least one power cord (21, 22, 23), ii) a protective earth conductor (25), and iii) one or more signal cables (26, 27) configured to transmit a signal or message that indicates that the cable (6) is connected; a cable interface unit (7) configured to receive and process the signal or message that indicates that the cable (6) is connected to the cable connector (5), wherein the cable interface unit (7) is configured to measure electric insulation between the at least one power cord (21, 22, 23) and the protective earth conductor (25) so as to allow for checking insulation capability of the cable (6) before applying high voltage to the cable (6).

## Description

A system for enabling safe transmittal of HV electric power from a towing vehicle to a trailer vehicle

### TECHNICAL FIELD

The disclosure relates generally to a system for transmitting HV (high voltage) electric power from a towing vehicle to a trailer vehicle. The disclosure can typically be applied to heavy-duty vehicles, such as a truck towing vehicle and a trailer application where electric power is needed for, for instance, refrigeration of the goods to be transported. Although the disclosure may be described with respect to a particular vehicle, the disclosure is not restricted to any particular vehicle.

### BACKGROUND

A conventional heavy-duty trailer that needs electric power normally makes use of grid power when available at stand-still and if power is needed also when driving a combustion engine driven electric generator arranged on the trailer is used. As the demand for zero emission vehicles is increasing, there is also an increasing interest for dispensing with such trailer-based generators.

When zero emission is required on the trailer, one solution is to install a battery on the trailer, but this is expensive, space consuming and require a charging method. Solutions built on fuel cells may be possible, but this is also quite space consuming, expensive and require access to hydrogen filling. Another solution is to provide electric power to the trailer from an electrically driven towing vehicle. However, high voltage safety is a main concern and no standard exists for how to connect electric HV power from the vehicle to the trailer. Work is ongoing to set a standard for how to connect DC from a vehicle battery to the trailer, but a DC supply requires a major rework of the trailer and it may take a long time before the standard is ready and trailers are rebuilt.

There is thus a need for improvements in the field of providing HV electric power to a consumer of HV electric power on a trailer vehicle.

### SUMMARY

According to a first aspect of the disclosure, it concerns a system for enabling safe transmittal of high voltage electric power from a towing vehicle to a trailer vehicle, wherein the system comprises the towing vehicle and wherein the towing vehicle comprises: a source of high voltage electric power; a cable connector connected to the source of high voltage electric power, wherein the cable connector is configured to be connected to a first end connector of a cable, and wherein the first end connector provides contact to the following components of the cable: i) at least one power cord for transmittance of the high voltage electric power to the trailer vehicle when the cable is connected to the towing vehicle and the trailer vehicle; ii) a protective earth conductor; and iii) one or more signal cables configured to transmit a signal or message that, when the cable is connected to the cable connector, indicates that the cable is connected, the towing vehicle further comprising: a cable interface unit connected to the cable connector, wherein the cable interface unit is configured to receive and process the signal or message that indicates that the cable is connected to the cable connector so as to establish that the cable is connected, and wherein the cable interface unit is provided with an insulation measurement device configured to measure electric insulation between the at least one power cord and the protective earth conductor when the cable is connected to the cable connector and a low voltage for cable test is applied between the at least one power cord and the protective earth conductor so as to allow for checking insulation capability of the cable when connected to the towing vehicle before applying high voltage to the cable from the source of high voltage electric power.

Many existing trailers are provided with an AC mains/grid power connection. By using a cable having a second (trailer) end connector adapted to such a trailer connection, the system/towing vehicle according to this disclosure provides for transmitting high voltage electric power from the towing (electric) vehicle to a standard trailer power connector while allowing for checking insulation capability of the cable when connected to the towing vehicle before applying high voltage to the cable so as to maintain electrical safety. That is, conventional trailers can be provided with electric power from the towing vehicle in a safe way without need for rework. The disclosed technology makes it possible for the vehicle to connect to the trailer in a way that meets the requirements for an IT network according to IEC 60364. Typically, the cable comprises several power cords and typically the insulation of all power cords is checked. That the cable connector of the towing vehicle is configured to be connected to the first end connector of the cable means that contact is established between the conductors of the cable and the cable interface when the cable is connected.

In some examples, including in at least one preferred example, the cable interface unit is configured to generate a warning signal or message, and/or prevent applying high voltage to the cable, if the measured electric insulation is below a threshold value. Such a warning signal or message may be displayed on a driver interface of the towing vehicle and/or may be indicated by a flashing LED indicator or in other ways at a position visible for the driver or other person who has connected the cable to the towing vehicle, such as on an auxiliary unit provided on the cable (see below).

In some examples, including in at least one preferred example, the cable interface unit is communicatively connected to a control system of the towing vehicle. Such a control system typically includes, for instance, a driver/user interface.

In some examples, including in at least one preferred example, the insulation measurement device comprises a sensor configured to directly or indirectly measure a current between the at least one power cord and the protective earth conductor of the cable when the cable is connected to the cable connector.

In some examples, including in at least one preferred example, the system comprises at least one temperature sensor arranged to generate a sensor signal representative of the temperature of the at least one power cord when the cable is connected to the cable connector.

In some examples, including in at least one preferred example, the system comprises at least one voltage sensor arranged to generate a sensor signal representative of the voltage of the at least one power cord when the cable is connected to the cable connector.

Temperature and voltage sensors provide for temperature and voltage monitoring of the cable and the connections when high voltage electric power is transmitted to the trailer. Information on temperature and voltage may be displayed on the driver/user interface and thus keep a driver updated during transport.

In some examples, including in at least one preferred example, the cable interface unit is configured to apply the low voltage for cable test between the at least one power cord and the protective earth conductor.

In some examples, including in at least one preferred example, the system further comprises the cable, wherein the first end connector of the cable provides contact to the following components that form part of the cable: i) at least one power cord for transmittance of the high voltage electric power to the trailer vehicle when the cable is connected to the towing vehicle and the trailer vehicle, ii) a protective earth conductor, and iii) one or more signal cables configured to transmit a signal or message that, when the cable is connected to the cable connector, indicates that the cable is connected; and wherein the cable has a second end connector configured to be connected to a trailer cable connector arranged on the trailer vehicle. As mentioned above, the trailer cable connector may be an AC mains/grid power connection. The cable typically comprises three power cords plus neutral plus protective earth and the second end connector may thus be a standard five-pin connector (in contrast to the first end connector).

In some examples, including in at least one preferred example, the protective earth conductor has the form of an electrical shield that extends along the cable and surrounds the at least one power cord. The protective earth (PE) may be denoted equipotential bonding (EPB) in the system of this disclosure.

In some examples, including in at least one preferred example, the cable is provided with an auxiliary unit configured to allow communication between the auxiliary unit and the cable interface unit via the one or more signal cables. The auxiliary unit may form an integrated part of the cable, it may for instance be bolted together with the connector at the second end of the cable or form a separate bulb on the cable. The auxiliary unit may be equipped with several components, such as a processing unit configured to provide for the communication between the auxiliary unit and the cable interface unit as well as the sensors for temperature and voltage monitoring of cable and connections. The auxiliary unit may further be provided with e.g. LED indicators for indicating cable status (power supplied to auxiliary unit, cable test completed, high voltage switched on, etc.)

In some examples, including in at least one preferred example, the auxiliary unit is configured to generate the signal or message that indicates that the cable is connected when the cable is connected to the cable connector. Communication between a processing unit in the auxiliary unit and the cable interface unit can thus be used as interlock. As an alternative or complement to generating the signal or message in the auxiliary unit, the one or more signal cables may form part of a high voltage interlock loop (HVIL), i.e. a loop that is closed when the cable is connected to the cable connector.

In some examples, including in at least one preferred example, the cable comprises a low voltage power supply cord for powering of the auxiliary unit, wherein the first end connector of the cable provides contact also to the low voltage power supply cord, and wherein the cable connector is adapted to be connected also to the low voltage power supply cord when connected to the first end connector so as to allow powering of the auxiliary unit from the towing vehicle. The low voltage power supply is typically 12 V or 24 V.

In some examples, including in at least one preferred example, the source of high voltage electric power is an AC source capable of generating a voltage in the range 200-1000 V (AC) or a DC source capable of generating a voltage of 300-1500 V (DC). More generally, the HV is > 30 VAC or > 60 VDC, but in many applications it is around 10 times higher.

In some examples, including in at least one preferred example, the low voltage for cable test is 60 V (DC) or less, or 30 V (AC) or less. For instance, the cable test voltage may be 24 V (DC).

In some examples, including in at least one preferred example, the system comprises the trailer vehicle, wherein the trailer vehicle comprises a trailer cable connector configured to be connected to a second end connector of the cable and, connected to the trailer cable connection, a receiver for the high voltage electric power. The HV receiver may be a power consumer, such as a refrigerating unit, but may also be an electric battery or other energy storage system.

According to a second aspect of the disclosure, it concerns a method for operating a system according to above where the system comprises also the cable, the method comprising: connecting the first end connector of the cable to the cable connector; establishing that the cable is connected by receiving and processing the signal or message that indicates that the cable is connected to the cable connector; applying the low voltage for cable test between the at least one power cord and the protective earth conductor; and measuring the electric insulation between the at least one power cord and the protective earth conductor using the insulation measurement device.

In some examples, including in at least one preferred example, the method further comprising: determining whether the measured electric insulation is below a threshold value; if the measured electric insulation is above the threshold, applying high voltage to the cable from the source of high voltage electric power, or, if the measured electric insulation is below the threshold, generating a warning signal or message, and/or preventing applying high voltage electric power to the cable.

According to a further aspect, the disclosure concerns a cable having a first end connector configured to be connected to the cable connector of the towing vehicle and a second end connector configured to be connected to a trailer cable connector of an AC mains/grid power connection type arranged on the trailer vehicle, the cable comprising i) at least one power cord for transmittance of the high voltage electric power to the trailer vehicle when the cable is connected to the towing vehicle and the trailer vehicle, ii) a protective earth conductor, such as an electrical shield extending along the cable and surrounding the at least one power cord, and iii) one or more signal cables configured to transmit a signal or message that, when the cable is connected to the cable connector, indicates that the cable is connected.

The cable may further comprise an auxiliary unit configured to allow communication between the auxiliary unit and the cable interface unit via the one or more signal cables when the cable is connected to the towing vehicle. The auxiliary unit may be structured, adapted and arranged as described further above. The cable may further comprise a low voltage power supply cord for powering of the auxiliary unit. Further, the cable may comprise three power cords plus neutral.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

### BRIEF DESCRIPTION OF THE DRAWINGS

Examples are described in more detail below with reference to the appended drawings.
**FIG. 1** shows a schematic example of a system for enabling safe transmittal of high voltage electric power from a towing vehicle to a trailer vehicle according to this disclosure.
**FIG. 2** shows a schematic example of a sectional view of a cable used in the system of figure 1.

### DETAILED DESCRIPTION

The detailed description set forth below provides information and examples of the disclosed technology with sufficient detail to enable those skilled in the art to practice the disclosure.

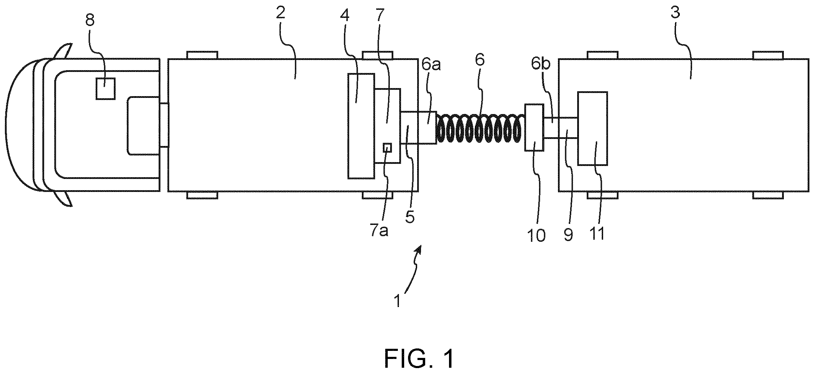

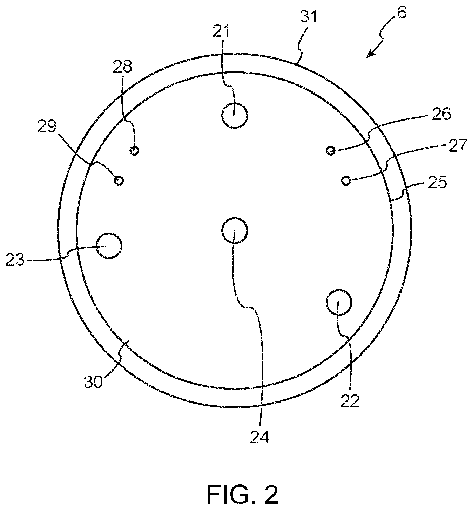

**FIG. 1** shows, in a view from above, a schematic example of a system 1 for enabling safe transmittal of high voltage (HV) electric power from a towing vehicle 2 to a trailer vehicle 3 according to this disclosure. **FIG. 2** shows a schematic example of a sectional view of a cable 6 used in the system of figure 1. Although the system 1 may comprise only the towing vehicle 2, or only the towing vehicle 2 and the cable 6, the example of figure 1 shows a system 1 comprising the towing vehicle 2, the cable 6 and also the trailer vehicle 3. A mechanical connection (not shown) is arranged between the towing vehicle 2 and the trailer vehicle 3.

As shown in figure 1, the towing vehicle 2 comprises a source of high voltage electric power 4 and a cable connector 5 connected to the source of high voltage electric power 4. The power source 4 is in this case a 3-phase power source capable of generating 400-480 VAC and 50/60 Hz. The HV electric power can be transmitted from the source 4 to the cable connector 5 and further to a consumer of electric power, in this case a refrigerating unit 11, arranged on the trailer vehicle 3 via the cable 6 when connected via first and second end connectors 6a, 6b to both the towing vehicle 2 and the trailer vehicle 3.

The cable connector 5 is configured to be connected to the first end 6a of the cable 6. As indicated schematically in figure 2, the cable 6 comprises three power cords 21, 22, 23, one neutral 24, a protective earth (PE) conductor in the form of an electrical shield 25 surrounding the power cords 21, 22, 23, signal cables 26, 27 configured to transmit a signal or message that indicates that the cable 6 is connected to the connector 5, low voltage power supply cables 28, 29, insulation material 30 and an outer covering 31. That the cable connector 5 is configured to be connected to the first end connector 6a of the cable 6 means that the cable connector 5 is arranged in a way corresponding to the first end connector 6a so that connection to the different cords and sub-cables of the cable 6 is established when the cable is connected. The cable connector 5 may be a special purpose female connector and the first end connector 6a of the cable may be a corresponding special purpose male connector. Figure 2 shows schematically the sectional view of the cable 6 at some position between the first end connector 6a and an auxiliary unit 10.

A second end connector 6b of the cable 6 is configured to be connected to a trailer cable connector 9 arranged on the trailer vehicle 3. The trailer cable connector 9 is in this example an AC mains/grid power connection type in the form of an IEC 60309 3-phase 5-pin male contact, and the second end connector 6b of the cable is a corresponding IEC 60309 3-phase 5-pin female contact.

A cable interface unit 7 is connected to the cable connector 5. The cable interface unit 7 comprises a process unit allowing communication with a vehicle control system 8 and thus with a driver interface. The cable interface unit 7 also forms an interface to the cable connector 5, and thus to the cable 6 when connected, and controls, for instance, when and if HV electric power is transmitted to the connector 5 and cable 6. As described below, the cable interface unit 7 also communicates with the auxiliary unit 10 forming part of the cable 6. The auxiliary unit 10 may be integrated in the second end connector 6b of the cable 6.

The auxiliary unit 10 is, by means of a processing unit, configured to allow communication between the auxiliary unit 10 and the cable interface unit 7 via the signal cables 26, 27. Further, the auxiliary unit 10 is configured to generate the signal or message that indicates that the cable 6 is connected when the first end connector 6a is connected to the cable connector 5. The low voltage power supply cables 28, 29 are used for powering of the auxiliary unit 10. The cable connector 5 is thus adapted to be connected also to the low voltage power supply cables 28, 29 when connected to the first end connector 6a so as to allow powering of the auxiliary unit 10 from the towing vehicle 2 using, for instance, 12 V or 24 V.

The auxiliary unit 10 is provided with at least one temperature sensor arranged to generate a sensor signal representative of the temperature of the at least one power cord 21, 22, 23 when the cable 6 is connected to the cable connector 5. The auxiliary unit 10 is also provided with voltage sensors arranged to generate a sensor signal representative of the voltage of each of power cord 21, 22, 23 when the cable 6 is connected to the cable connector 5. Information on current temperature and voltages may be sent intermittently to the cable interface unit 7 and further to the vehicle control system 8 and user/driver interface. The temperature and/or voltage sensors may alternatively be placed e.g. in association with the cable connector 5.

The cable interface unit 7 is configured to receive and process the signal or message that indicates that the cable 6 is connected to the cable connector 5 so as to establish that the cable 5 is connected. The cable interface unit 7 is further configured to apply a low voltage, such as 25 V, for cable test between the at least one power cord 21, 22, 23 and the protective earth conductor 25 when the cable 6 is connected to the cable connector 5.

The cable interface unit 7 is also provided with an insulation measurement device 7a configured to measure electric insulation between the at least one power cord 21, 22, 23 and the protective earth conductor 25 when the cable 6 is connected to the cable connector 5 and the low voltage is applied so as to allow for checking insulation capability of the cable 6 when connected to the towing vehicle 2 before applying high voltage to the cable 6 from the source of high voltage electric power 4. The insulation measurement device 7a comprises a sensor configured to directly or indirectly measure a current between the at least one power cord 21, 22, 23 and the protective earth conductor 25 of the cable 6 when the cable 6 is connected to the cable connector 5. Such devices are known as such.

The cable interface unit 7 is configured to generate a warning signal or message, and/or prevent applying high voltage to the cable 6, if the measured electric insulation is below a threshold value. The auxiliary unit 10 is in this case provided with LED indicators to display such a warning signal or message. Also status of the cable 6, such as whether HV is applied or not, is indicated on the auxiliary unit 10.

A method for operating the system 1 may include the following:
- connecting the first end connector 6a of the cable 6 to the cable connector 5 (without connecting the second end 6b to the trailer connector 9 unless certified that insulation test at low voltage can be made with the particular trailer involved);
- establishing, by the cable interface unit 7, that the cable 6 is connected by receiving and processing the signal or message that indicates that the cable 6 is connected to the cable connector 5;
- applying, by the cable interface unit 7, the low voltage for cable test between each of the power cords 21, 22, 23 and the protective earth conductor 25 (which all are connected to the connector 5 and thereby to the cable interface unit 7);
- measuring, using the insulation measurement device 7a, the electric insulation between each of the power cords 21, 22, 23 and the protective earth conductor 25;
- determining whether the measured electric insulation is below a threshold value; and if the measured electric insulation is above the threshold:
- applying high voltage to the cable 6 from the source of high voltage electric power 4 (which may be indicated by a LED on the auxiliary unit 10), or
   if the measured electric insulation is below the threshold,
- generating a warning signal or message (which may be displayed on the auxiliary unit 10), and/or preventing applying high voltage electric power to the cable 6.

The following is a form of summary of the exemplified system 1:

### General points

- Auxiliary unit 10 integrated with cable 6 (second end connector bolted together with the auxiliary unit 10, or auxiliary unit 10 implemented as a bulb on the cable 6) and powered from the towing vehicle 2.
- Communication between auxiliary unit 10 and cable interface unit 7 used as interlock (optionally separate HVIL).
- The towing vehicle 2/the cable interface unit 7 has IRM (Isolation Resistance Monitoring, compliant with IEC 61557-8 or similar) and RCD (Residual Current Detection, compliant with IEC 61557-6 or similar).
- Safe start-up ensured with a pre-test feature (insulation test at low voltage).
- Temperature monitoring at second end connector 6a of cable 6 (and optionally on vehicle end).

### Vehicle power unit/ source of high voltage electric power 4

Typically, 3-phase 400-480VAC 50/60Hz, Neutral, PE (Protective Earth) / EPB (Equipotential Bonding), Fuse function (typically, 16A or 32A, type C).

### Cable interface unit 5

Typical functions: RCD (Residual Current Detection), Isolation monitoring (IRM), Vehicle communication, Low voltage cable test, Auxiliary unit 10 communication (CAN).

### Cable 6

Typically, a spiral cable. Power cords 5*6mm2 (L1, L2, L3, N, PE). Shield, at least 4mm2. A twisted pair signal cables for communication between cable interface unit 7 and cable auxiliary unit 10. Low voltage power supply to cable interface (typically 12V or 24V).

### Auxiliary unit 10

Temperature monitoring (cable and preferably connector terminals).

Voltage monitoring of all power cords except PE/EPB.

Communication with cable interface.

Periodic transmission of voltage and temperature.

Red, and green indication LED, lit as per commanded from cable interface.

Yellow LED lit as soon as low voltage power supply is applied.

The system and method of this disclosure can be used in any electric vehicle system where a trailer can be connected, typically battery powered but for instance fuel cell powered vehicle would also benefit. The system is described for AC but would work for DC also. If only two signal pins are available power supply may be phantomized between CAN and shield. Communication may act as interlock, but additional HVIL can be added.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A system (1) for enabling safe transmittal of high voltage electric power from a towing vehicle (2) to a trailer vehicle (3),
wherein the system (1) comprises the towing vehicle (2) and wherein the towing vehicle (2) comprises:
- a source of high voltage electric power (4);
- a cable connector (5) connected to the source of high voltage electric power (4),
wherein the cable connector (5) is configured to be connected to a first end connector (6a) of a cable (6), and wherein the first end connector (6a) provides contact to the following components of the cable (6): i) at least one power cord (21, 22, 23) for transmittance of the high voltage electric power to the trailer vehicle (3) when the cable (6) is connected to the towing vehicle (2) and the trailer vehicle (3), ii) a protective earth conductor (25), and iii) one or more signal cables (26, 27) configured to transmit a signal or message that, when the cable (6) is connected to the cable connector (5), indicates that the cable (6) is connected;
the towing vehicle (2) further comprising:
- a cable interface unit (7) connected to the cable connector (5),
wherein the cable interface unit (7) is configured to receive and process the signal or message that indicates that the cable (6) is connected to the cable connector (5) so as to establish that the cable (5) is connected,
wherein the cable interface unit (7) is provided with an insulation measurement device (7a) configured to measure electric insulation between the at least one power cord (21, 22, 23) and the protective earth conductor (25) when the cable (6) is connected to the cable connector (5) and a low voltage for cable test is applied between the at least one power cord (21, 22, 23) and the protective earth conductor (25) so as to allow for checking insulation capability of the cable (6) when connected to the towing vehicle (2) before applying high voltage to the cable (6) from the source of high voltage electric power (4).

2. The system (1) of claim 1, wherein the cable interface unit (7) is configured to generate a warning signal or message, and/or prevent applying high voltage to the cable (6), if the measured electric insulation is below a threshold value.

3. The system (1) of claim 1 or 2, wherein the cable interface unit (7) is communicatively connected to a control system (8) of the towing vehicle (2).

4. The system (1) of any of the above claims, wherein the insulation measurement device (7a) comprises a sensor configured to directly or indirectly measure a current between the at least one power cord (21, 22, 23) and the protective earth conductor (25) of the cable (6) when the cable (6) is connected to the cable connector (5).

5. The system (1) of any of the above claims, wherein the system (1) comprises at least one temperature sensor arranged to generate a sensor signal representative of the temperature of the at least one power cord (21, 22, 23) when the cable (6) is connected to the cable connector (5).

6. The system (1) of any of the above claims, wherein the system (1) comprises at least one voltage sensor arranged to generate a sensor signal representative of the voltage of the at least one power cord (21, 22, 23) when the cable (6) is connected to the cable connector (5).

7. The system (1) of any of the above claims, wherein the cable interface unit (7) is configured to apply the low voltage for cable test.

8. The system (1) of any of the above claims, wherein the system (1) further comprises the cable (6), wherein the first end connector (6a) of the cable (6) provides contact to the following components that form part of the cable (6): i) at least one power cord (21, 22, 23) for transmittance of the high voltage electric power to the trailer vehicle (3) when the cable (6) is connected to the towing vehicle (2) and the trailer vehicle (3), ii) a protective earth conductor (25), and iii) one or more signal cables (26, 27) configured to transmit a signal or message that, when the cable (6) is connected to the cable connector (5), indicates that the cable (6) is connected; and wherein the cable (6a) has a second end connector (6b) configured to be connected to a trailer cable connector (9) arranged on the trailer vehicle (3).

9. The system (1) of claim 8, wherein the protective earth conductor (25) has the form of an electrical shield (25) that extends along the cable (6) and surrounds the at least one power cord (21, 22, 23),

10. The system (1) of claim 8 or 9, wherein the cable (6) is provided with an auxiliary unit (10) configured to allow communication between the auxiliary unit (10) and the cable interface unit (7) via the one or more signal cables (26, 27).

11. The system (1) of claim 9, wherein the auxiliary unit (10) is configured to generate the signal or message that indicates that the cable (6) is connected when the cable is connected to the cable connector (5).

12. The system (1) of any of claims 10-11, wherein the cable (6) comprises a low voltage power supply cord (28, 29) for powering of the auxiliary unit (10), wherein the first end connector (6a) of the cable (6) provides contact also to the low voltage power supply cord (28, 29), and wherein the cable connector (5) is adapted to be connected also to the low voltage power supply cord (28, 29) when connected to the first end connector (6a) so as to allow powering of the auxiliary unit (10) from the towing vehicle (2).

13. The system (1) of any of the above claims, wherein the system (1) comprises the trailer vehicle (3), and wherein the trailer vehicle (3) comprises a trailer cable connector (9) configured to be connected to a second end connector (6b) of the cable (6) and, connected to the trailer cable connection (9), a receiver (11) for the high voltage electric power.

14. A method for operating a system (1) according to claim 8, the method comprising:
- connecting the first end connector (6a) of the cable (6) to the cable connector (5);
- establishing that the cable (6) is connected by receiving and processing the signal or message that indicates that the cable (6) is connected to the cable connector (5);
- applying the low voltage for cable test between the at least one power cord (21, 22, 23) and the protective earth conductor (25);
- measuring the electric insulation between the at least one power cord (21, 22, 23) and the protective earth conductor (25) using the insulation measurement device (7a).

15. The method of claim 14, wherein the system (1) is arranged also according to claim 2, the method further comprising:
- determining whether the measured electric insulation is below a threshold value; and if the measured electric insulation is above the threshold,
- applying high voltage to the cable (6) from the source of high voltage electric power (4), or, if the measured electric insulation is below the threshold,
- generating a warning signal or message, and/or preventing applying high voltage electric power to the cable (6).
